# EUROPEAN PATENT APPLICATION

(11) **EP 4 318 131 A1**
(43) Date of publication of application: **07.02.2024**
(21) Application number: 22188074.3
(22) Date of filing: 01.08.2022
(51) Int. Cl.: G03F 7/20, G03H 1/04

(54) **SENSOR MODULE, ILLUMINATOR, METROLOGY DEVICE AND ASSOCIATED METROLOGY METHOD**

(71) Applicant: ASML Netherlands B.V., 5500 AH Veldhoven (NL)
(72) Inventor: VAN SCHAIJK, Theodorus, Thomas, Marinus, 5500 AH Veldhoven (NL); BUIJS, Robin, Daniel, 5500AH Veldhoven (NL); DEN BOEF, Arie, Jeffrey, 5500 AH Veldhoven (NL); DE WIT, Johannes, Matheus, Marie, 5500 AH Veldhoven (NL); TUKKER, Teunis, Willem, 5500 AH Veldhoven (NL)
(74) Representative: ASML Netherlands B.V.

(57) **Abstract**

A sensor module is disclosed for a metrology apparatus. The sensor module comprises an illumination device for illuminating a structure on a substrate, said illumination device comprising at least a first set of illuminators and a second set of illuminators, wherein said first set of illuminators comprise one or more illuminators which are each operable to illuminate said structure with first illumination comprising a first optical characteristic and wherein said second set of illuminators comprise one or more illuminators which are each operable to illuminate said structure with second illumination comprising a second optical characteristic different to said first optical characteristic; an optical system being operable to capture scattered radiation scattered by the structure resultant from the structure being illuminated; and a detector operable to detect the scattered radiation.

## Description

### FIELD

The present invention relates to metrology such as digital holographic microscopy and in particular high speed dark field digital holographic microscopy and in relation to metrology applications in the manufacture of integrated circuits.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-k₁ lithography may be used to process features with dimensions smaller than the classical resolution limit of a lithographic apparatus. In such process, the resolution formula may be expressed as CD = k₁×λ/NA, where λ is the wavelength of radiation employed, NA is the numerical aperture of the projection optics in the lithographic apparatus, CD is the "critical dimension" (generally the smallest feature size printed, but in this case half-pitch) and k₁ is an empirical resolution factor. In general, the smaller k₁ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

During the manufacturing process there is a need to inspect the manufactured structures and/or to measure characteristics of the manufactured structures. Suitable inspection and metrology apparatuses are known in the art. One of the known metrology apparatuses is a scatterometer and, for example, a dark field scatterometer.

Patent application publication US2016/0161864A1, patent application publication US2010/0328655A1 and patent application publication US2006/0066855A1 discuss embodiments of a photolithographic apparatus and embodiments of a scatterometer. The cited documents are herein incorporated by reference.

Metrology devices mentioned above, and more generally, may have the problem of having the range of wavelengths for illumination and detection limited. In particular, it may be desirable to operate the metrology device over a wavelength range of, for example, 400 nm to 1600 nm. However, it may be difficult to design and/or implement suitable illumination optics for this bandwidth.

For example, in the context of digital microscopy, a microscope operable over this bandwidth has been addressed by implementing reflective optical components. However, these reflective optical components are difficult to manufacture and align. The issue has also been addressed by implementing a larger number of lens elements. As a result, component cost and device complexity is undesirably increased. Furthermore, the issue has been addressed by implementing a small number of lens elements, for example less than three lens elements. However, using a small number of lens elements means it is more difficult to produce a suitably sized illumination spot on the structure over the entire wavelength range, and it is not possible for the illuminator to produce an illumination spot having a flat intensity profile.

Additionally, an optical fiber connecting the fixed world to a sensing module may be optimized for a particular optical characteristic, such as wavelength range, polarization, or spot size, and may be unsuitable for operating at optical characteristics outside of the particular optical characteristic.

It is desirable to provide an illumination device for a metrology device suitable for use over a wide wavelength range.

### SUMMARY

In a first aspect of the invention, there is provided a sensor module for a metrology apparatus, the sensor module comprising: an illumination device for illuminating a structure on a substrate, said illumination device comprising at least a first set of illuminators and a second set of illuminators, wherein said first set of illuminators comprise one or more illuminators which are each operable to illuminate said structure with first illumination comprising a first optical characteristic and wherein said second set of illuminators comprise one or more illuminators which are each operable to illuminate said structure with second illumination comprising a second optical characteristic different to said first optical characteristic; an optical system being operable to capture scattered radiation scattered by the structure resultant from the structure being illuminated; and a detector operable to detect the scattered radiation.

In a second aspect of the invention there is provided an illumination device for a metrology apparatus; the illumination device comprising: a first set of illuminators comprising one or more illuminators which are each operable to emit first illumination comprising a first optical characteristic; a second set of illuminators, comprising one or more illuminators which are each operable to emit second illumination comprising a second optical characteristic different to said first optical characteristic; and an illuminator holding means accommodating the first set of illuminators and the second set of illuminators.

### BRIEF DESCRIPTION OF THE DRAWINGS

Embodiments of the invention will now be described, by way of example only, with reference to the accompanying schematic drawings, in which:
- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 depicts a schematic overview of a scatterometry apparatus used as a metrology device, which may comprise a dark field digital holographic microscope according to embodiments of the invention;
- Figure 5 depicts a schematic overview of a level sensor apparatus which may comprise a dark field digital holographic microscope according to embodiments of the invention;
- Figure 6 depicts a schematic overview of an alignment sensor apparatus which may comprise a dark field digital holographic microscope according to embodiments of the invention;
- Figure 7 depicts schematically an example of a diffraction-based dark field metrology device operated in a parallel acquisition scheme;
- Figure 8 depicts schematically a different example of a diffraction-based dark field metrology device operated in a sequential acquisition scheme;
- Figure 9 depicts schematically an example of a dark field digital holographic microscope operated in a sequential acquisition scheme;
- Figure 10 depicts schematically a dark field digital holographic microscope (df-DHM) operated in a parallel acquisition scheme;
- Figure 11A depicts schematically a dark field digital holographic microscope (df-DHM) operated in a sequential acquisition scheme, in accordance with an embodiment;
   Figure 11B depicts schematically the geometric NA-space of the df-DHM illustrated in Figure 11A in accordance with an embodiment;
   Figure 11C depicts schematically a schematic representation of an example arrangement of an illumination device;
   Figure 12A depicts schematically a dark field digital holographic microscope (df-DHM) operated in a parallel acquisition scheme, in accordance with an embodiment;
   Figure 12B depicts schematically the geometric NA-space of the df-DHM illustrated in Figure 12A in accordance with an embodiment; and
- Figure 13 depicts a block diagram of a computer system for controlling a dark field digital holographic microscope.

### DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

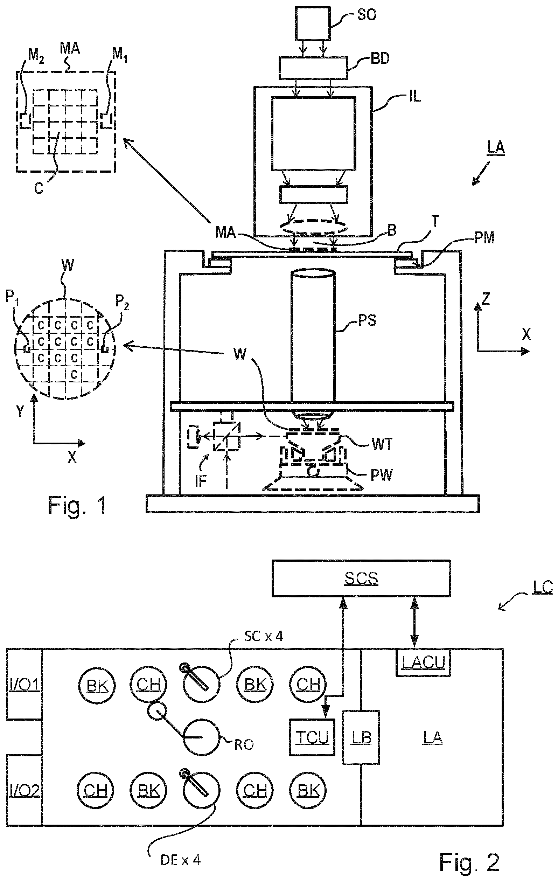

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks PI, P2 are known as scribe-lane alignment marks when these are located between the target portions C.

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

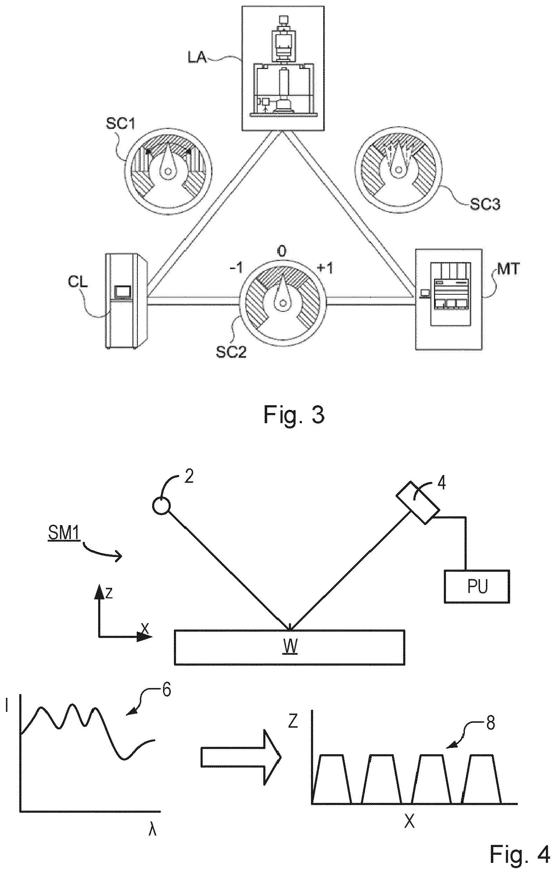

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

In lithographic processes, it is desirable to make frequently measurements of the structures created, e.g., for process control and verification. Tools to make such measurement are typically called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from soft x-ray and visible to near-IR wavelength range.

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is a ellipsometric scatterometer. The ellipsometric scatterometer allows for determining parameters of a lithographic process by measuring scattered radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (typically overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for measuring overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after etch process for example. Typically the pitch and line-width of the structures in the gratings strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resembles the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

A metrology apparatus, such as a scatterometer, is depicted in Figure 4. It comprises a broadband (white light) radiation projector 2 which projects radiation onto a substrate W. The reflected or scattered radiation is passed to a spectrometer detector 4, which measures a spectrum 6 (i.e. a measurement of intensity as a function of wavelength) of the specular reflected radiation. From this data, the structure or profile 8 giving rise to the detected spectrum may be reconstructed by processing unit PU, e.g. by Rigorous Coupled Wave Analysis and non-linear regression or by comparison with a library of simulated spectra as shown at the bottom of Figure 3. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

Overall measurement quality of a lithographic parameter via measurement of a metrology target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1incorporated herein by reference in its entirety.

Another type of metrology tool used in IC manufacture is a topography measurement system, level sensor or height sensor. Such a tool may be integrated in the lithographic apparatus, for measuring a topography of a top surface of a substrate (or wafer). A map of the topography of the substrate, also referred to as height map, may be generated from these measurements indicating a height of the substrate as a function of the position on the substrate. This height map may subsequently be used to correct the position of the substrate during transfer of the pattern on the substrate, in order to provide an aerial image of the patterning device in a properly focus position on the substrate. It will be understood that "height" in this context refers to a dimension broadly out of the plane to the substrate (also referred to as Z-axis). Typically, the level or height sensor performs measurements at a fixed location (relative to its own optical system) and a relative movement between the substrate and the optical system of the level or height sensor results in height measurements at locations across the substrate.

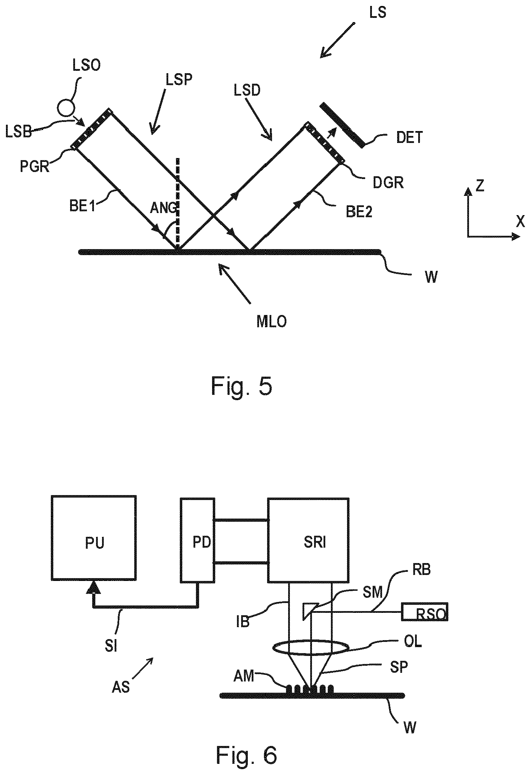

An example of a level or height sensor LS as known in the art is schematically shown in Figure 5, which illustrates only the principles of operation. In this example, the level sensor comprises an optical system, which includes a projection unit LSP and a detection unit LSD. The projection unit LSP comprises a radiation source LSO providing a beam of radiation LSB which is imparted by a projection grating PGR of the projection unit LSP. The radiation source LSO may be, for example, a narrowband or broadband light source, such as a supercontinuum light source, polarized or non-polarized, pulsed or continuous, such as a polarized or non-polarized laser beam. The radiation source LSO may include a plurality of radiation sources having different colors, or wavelength ranges, such as a plurality of LEDs. The radiation source LSO of the level sensor LS is not restricted to visible radiation, but may additionally or alternatively encompass UV and/or IR radiation and any range of wavelengths suitable to reflect from a surface of a substrate.

The projection grating PGR is a periodic grating comprising a periodic structure resulting in a beam of radiation BE1 having a periodically varying intensity. The beam of radiation BE1 with the periodically varying intensity is directed towards a measurement location MLO on a substrate W having an angle of incidence ANG with respect to an axis perpendicular (Z-axis) to the incident substrate surface between 0 degrees and 90 degrees, typically between 70 degrees and 80 degrees. At the measurement location MLO, the patterned beam of radiation BE1 is reflected by the substrate W (indicated by arrows BE2) and directed towards the detection unit LSD.

In order to determine the height level at the measurement location MLO, the level sensor further comprises a detection system comprising a detection grating DGR, a detector DET and a processing unit (not shown) for processing an output signal of the detector DET. The detection grating DGR may be identical to the projection grating PGR. The detector DET produces a detector output signal indicative of the light received, for example indicative of the intensity of the light received, such as a photodetector, or representative of a spatial distribution of the intensity received, such as a camera. The detector DET may comprise any combination of one or more detector types.

By means of triangulation techniques, the height level at the measurement location MLO can be determined. The detected height level is typically related to the signal strength as measured by the detector DET, the signal strength having a periodicity that depends, amongst others, on the design of the projection grating PGR and the (oblique) angle of incidence ANG.

The projection unit LSP and/or the detection unit LSD may include further optical elements, such as lenses and/or mirrors, along the path of the patterned beam of radiation between the projection grating PGR and the detection grating DGR (not shown).

In an embodiment, the detection grating DGR may be omitted, and the detector DET may be placed at the position where the detection grating DGR is located. Such a configuration provides a more direct detection of the image of the projection grating PGR.

In order to cover the surface of the substrate W effectively, a level sensor LS may be configured to project an array of measurement beams BE1 onto the surface of the substrate W, thereby generating an array of measurement areas MLO or spots covering a larger measurement range.

Various height sensors of a general type are disclosed for example in US7265364 and US7646471, both incorporated by reference. A height sensor using UV radiation instead of visible or infrared radiation is disclosed in US2010233600A1, incorporated by reference. In WO2016102127A1, incorporated by reference, a compact height sensor is described which uses a multi-element detector to detect and recognize the position of a grating image, without needing a detection grating.

Another type of metrology tool used in IC manufacture is an alignment sensor. A critical aspect of performance of the lithographic apparatus is therefore the ability to place the applied pattern correctly and accurately in relation to features laid down in previous layers (by the same apparatus or a different lithographic apparatus). For this purpose, the substrate is provided with one or more sets of marks or targets. Each mark is a structure whose position can be measured at a later time using a position sensor, typically an optical position sensor. The position sensor may be referred to as "alignment sensor" and marks may be referred to as "alignment marks".

A lithographic apparatus may include one or more (e.g. a plurality of) alignment sensors by which positions of alignment marks provided on a substrate can be measured accurately. Alignment (or position) sensors may use optical phenomena such as diffraction and interference to obtain position information from alignment marks formed on the substrate. An example of an alignment sensor used in current lithographic apparatus is based on a self-referencing interferometer as described in US6961116. Various enhancements and modifications of the position sensor have been developed, for example as disclosed in US2015261097A1. The contents of all of these publications are incorporated herein by reference.

Figure 6 is a schematic block diagram of an embodiment of a known alignment sensor AS, such as is described, for example, in US6961116, and which is incorporated by reference. Radiation source RSO provides a beam RB of radiation of one or more wavelengths, which is diverted by diverting optics onto a mark, such as mark AM located on substrate W, as an illumination spot SP. In this example the diverting optics comprises a spot mirror SM and an objective lens OL. The illumination spot SP, by which the mark AM is illuminated, may be slightly smaller in diameter than the width of the mark itself.

Radiation diffracted by the alignment mark AM is collimated (in this example via the objective lens OL) into an information-carrying beam IB. The term "diffracted" is intended to include zero-order diffraction from the mark (which may be referred to as reflection). A self-referencing interferometer SRI, e.g. of the type disclosed in US6961116 mentioned above, interferes the beam IB with itself after which the beam is received by a photodetector PD. Additional optics (not shown) may be included to provide separate beams in case more than one wavelength is created by the radiation source RSO. The photodetector may be a single element, or it may comprise a number of pixels, if desired. The photodetector may comprise a sensor array.

The diverting optics, which in this example comprises the spot mirror SM, may also serve to block zero order radiation reflected from the mark, so that the information-carrying beam IB comprises only higher order diffracted radiation from the mark AM (this is not essential to the measurement, but improves signal to noise ratios).

Intensity signals SI are supplied to a processing unit PU. By a combination of optical processing in the block SRI and computational processing in the unit PU, values for X- and Y-position on the substrate relative to a reference frame are output.

A single measurement of the type illustrated only fixes the position of the mark within a certain range corresponding to one pitch of the mark. Coarser measurement techniques are used in conjunction with this to identify which period of a sine wave is the one containing the marked position. The same process at coarser and/or finer levels may be repeated at different wavelengths for increased accuracy and/or for robust detection of the mark irrespective of the materials from which the mark is made, and materials on and/or below which the mark is provided. The wavelengths may be multiplexed and de-multiplexed optically so as to be processed simultaneously, and/or they may be multiplexed by time division or frequency division.

In this example, the alignment sensor and spot SP remain stationary, while it is the substrate W that moves. The alignment sensor can thus be mounted rigidly and accurately to a reference frame, while effectively scanning the mark AM in a direction opposite to the direction of movement of substrate W. The substrate W is controlled in this movement by its mounting on a substrate support and a substrate positioning system controlling the movement of the substrate support. A substrate support position sensor (e.g. an interferometer) measures the position of the substrate support (not shown). In an embodiment, one or more (alignment) marks are provided on the substrate support. A measurement of the position of the marks provided on the substrate support allows the position of the substrate support as determined by the position sensor to be calibrated (e.g. relative to a frame to which the alignment system is connected). A measurement of the position of the alignment marks provided on the substrate allows the position of the substrate relative to the substrate support to be determined.

In order to monitor the lithographic process, parameters of the patterned substrate are measured. Parameters may include, for example, the overlay error between successive layers formed in or on the patterned substrate. This measurement may be performed on a product substrate and/or on a dedicated metrology target. There are various techniques for making measurements of the microscopic structures formed in lithographic processes, including the use of scanning electron microscopes and various specialized tools. A fast and non-invasive form of specialized inspection tool is a scatterometer in which a beam of radiation is directed onto a target on the surface of the substrate and properties of the scattered or reflected beam are measured.

Examples of known scatterometers include angle-resolved scatterometers of the type described in US2006033921A1 and US2010201963A1. The targets used by such scatterometers are relatively large, e.g., 40µm by 40µm, gratings and the measurement beam generates a spot that is smaller than the grating (i.e., the grating is underfilled). In addition to measurement of feature shapes by reconstruction, diffraction based overlay can be measured using such apparatus, as described in published patent application US2006066855A1. Diffraction-based overlay metrology using dark field imaging of the diffraction orders enables overlay measurements on smaller targets. Examples of dark field imaging metrology can be found in international patent applications WO 2009/078708 and WO 2009/106279 which documents are hereby incorporated by reference in their entirety. Further developments of the technique have been described in published patent publications US20110027704A, US20110043791A, US2011102753A1, US20120044470A, US20120123581A, US20130258310A, US20130271740A and WO2013178422A1. These targets can be smaller than the illumination spot and may be surrounded by product structures on a wafer. Multiple gratings can be measured in one image, using a composite grating target. The contents of all these applications are also incorporated herein by reference.

Dark field microscopes, such as the metrology device mentioned above and more generally, have the problem of having a limited range of angles for illumination of the target and/or detection of the light that is diffracted by the target, as it may be required that the total range of angles (corresponding to regions within the angle resolved pupil) are shared between the illumination path and detection path. This limits the effective NA in illumination and detection.

In a diffraction-based dark field metrology device, a beam of radiation is directed onto a metrology target and one or more properties of the scattered radiation are measured so as to determine a property of interest of the target. The properties of the scattered radiation may comprise, for example, intensity at a single scattering angle (e.g., as a function of wavelength) or intensity at one or more wavelengths as a function of scattering angle.

Measurement of targets in dark field metrology may comprise, for example, measuring the a first intensity of the 1^{st} diffraction order I₊₁ and a second intensity of the -1^{st} diffraction order (I₋₁) and calculating an intensity asymmetry (A = I₊₁ - I₋₁), which is indicative of asymmetry in the target. The metrology targets may comprise one or more grating structures from which a parameter of interest may be inferred from such intensity asymmetry measurements, e.g., the targets are designed such that the asymmetry in the target varies with the parameter of interest. For example, in overlay metrology a target may comprise at least one composite grating formed by at least a pair of overlapping sub-gratings that are patterned in different layers of the semiconductor device. Asymmetry of the target will therefore be dependent on alignment of the two layers and therefore overlay. Other targets may be formed with structures which are exposed with different degrees of variation based on the focus setting used during the exposure; the measurement of which enabling that focus setting to be inferred back (again through intensity asymmetry).

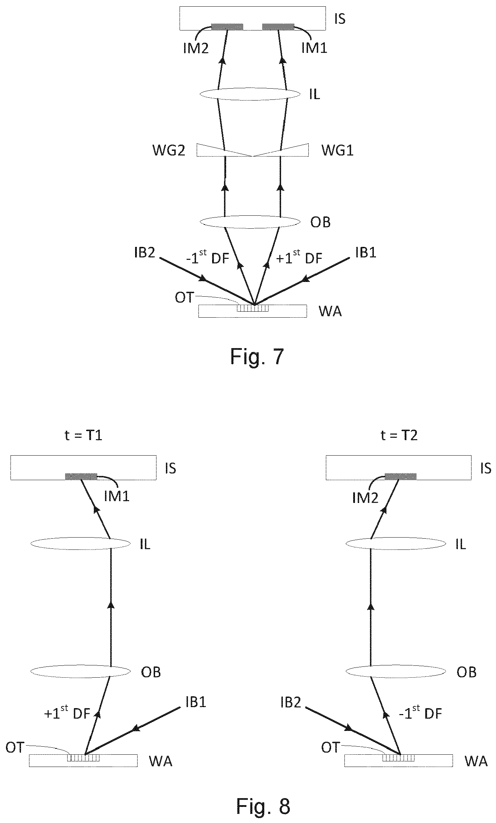

Figure 7 and Figure 8 schematically illustrate two examples of diffraction-based dark field metrology devices. Note that for the sake of simplicity, both figures only show some of the components that are sufficient for the purpose of describing working principle of the two devices.

As illustrated in Figure 7, a first illumination beam of radiation IB1 may be obliquely incident onto an overlay target of a substrate WA from one side of the device. The grating based overlay target may diffract the first illumination beam into a number of diffraction orders. Since the device is configured for dark field imaging, the zeroth diffraction order may be either blocked by an optical component or configure to fall completely outside the numerical aperture of the objective lens OB. At least one non-zeroth diffraction order, e.g., positive first diffraction order +1^{st} DF, may be collected by the objective lens OB. At the pupil plane of the objective lens OB, a first wedge WG1 may be used to re-direct the diffracted radiation to follow a desired beam path. Finally, an imaging lens may be used to focus the diffraction order, e.g., positive first diffraction order +1^{st} DF, onto an image sensor IS such that a first image IM1 is formed at a first location.

Similarly, a second illumination beam of radiation IB2 may be obliquely incident onto the same overlay target OT of the substrate WA from the opposite side of the system. The incident angle of the second illumination beam IB2 may be same as that of the first illumination beam IB1. At least one non-zeroth diffraction order, e.g., negative first diffraction order -1^{st} DF, may be collected by the objective lens OB and subsequently redirected by a second wedge WG2. The negative first diffraction order -1^{st} DF may then be focused by the imaging lens IL onto the image sensor IS such that a second image IM2 is formed at a second location.

The example of Figure 7 is operated in a parallel acquisition scheme. The overlay target is illuminated simultaneously by both illumination beams IB1, IB2. Correspondingly, the two spatially separated images IM1, IM2 of the overlay target are acquired at the same time. Such a parallel acquisition scheme allows for a fast measurement speed and hence high throughput. However, the pupil plane of the objective lens OB has to be shared by the two diffraction orders, e.g., +1^{st} DF and -1^{st} DF. A consequence of dividing the pupil into mutually exclusive illumination and detection pupils is that there is a consequent reduction in the illumination NA and in the detection NA. While there is some flexibility in trade-off between the illumination NA and detection NA, ultimately having both the illumination NA the detection NA as large as is often desirable is not possible within a single pupil. This results in a limited range of angles for each corresponding illumination beam and for the +1^{st} DF and -1^{st} DF beams, which in turn limits the range of allowable grating pitch sizes and/or illumination wavelengths and hence imposes a tight requirement for designing such a metrology system.

Figure 8 schematically illustrates another exemplary dark field metrology device (or different operation mode of the device of Figure 7). The main difference is that the metrology device of Figure 8 is operated in a sequential acquisition scheme. In the sequential acquisition scheme, a metrology target OT is only illuminated by one illumination beam from one direction at any time instance and thereby only one image of the target is formed and acquired at any point in time. Referring to Figure 8, at a first time instance t=T1, a first illumination beam IB1 may be switched on and directed obliquely onto an overlay target OT of a substrate WA from one side of the metrology device. After interaction with the gratings of the overlay target, a number of diffraction orders may be generated. At least one of the non-zeroth diffraction order, e.g., positive first diffraction order +1^{st} DF, may be collected by an objective lens OB and subsequently focused by an imaging lens IL onto an image sensor IS.

Subsequent to the first image IM1 of the overlay gratings being acquired, at a second time instance t=T2, the first illumination beam IB1 is switched off and a second illumination beam IB2 is switched on. The second illumination beam IB2 may be directly obliquely onto the same overlay target from an opposite side of the metrology device. At least one of the generated diffraction orders, e.g., negative first diffraction order -1^{st} DF, may be collected by the objective lens OB and subsequently focused onto the image sensor IS to form a second image IM2 of the overlay target. Note that both images IM1 and IM2 may be formed at a common position on the image sensor.

With this time multiplexed acquisition scheme, the full NA of the objective lens OB is made available for detecting the diffracted beams + 1^{st} DF and -1^{st} DF. No limitation in objective NA means a wider range of relevant design parameters, such as grating pitch sizes, illumination wavelengths and illumination angles, is allowed and a greater flexibility in system design can be obtained. However, the fact that multiple image acquisitions are needed means measurement speed is reduced and hence system throughput is impacted.

In addition, accurate determination of e.g., overlay error, relies on accurate measurement of a minute relative intensity difference (or intensity asymmetry) between the two acquired images IM1, IM2. The typical relative intensity difference is on the order of 10⁻⁴ of the intensity of one of the acquired images, e.g., IM1 or IM2. Such a small intensity difference could easily be dwarfed by any intensity and/or wavelength fluctuations of illumination radiation. Therefore, the illumination beams are required to stay stable during consecutive image acquisitions. This can be achieved by using a stable light source providing desired intensity and wavelength stabilities. Alternatively, additional hardware and software, such as for example intensity/wavelength monitoring device and corresponding feedback control loop, should be incorporated into the metrology device such that intensity and/or wavelength fluctuations of the illumination beams are actively monitored and well compensated. In some cases, an intensity monitoring device may be used to actively track the intensity of the illumination beams. The signal generated from the intensity monitoring device may be used to (e.g., electronically) correct the intensity fluctuations of the illumination beams. All these solutions add complexity and cost to the overall system.

Some or all of aforementioned problems could be addressed by using digital holographic microscopy, in particular dark field digital holographic microscopy. Digital holographic microscopy is an imaging technology that combines holography with microscopy. Different from other microscopy methods that record projected images of an object, digital holographic microscopy records holograms formed by interference between object radiation obtained by irradiation of a three-dimensional (3D) object with object radiation and reference radiation that is coherent with the object radiation. Images may be captured using, for example a charge coupled device (CCD) or a complementary metal oxide semiconductor (CMOS). Since the object radiation is radiation scattered from the object, wave-front of the object radiation is therefore modulated or shaped by the object. The scattered radiation may comprise reflected radiation, diffracted radiation, or transmitted radiation. Therefore, the wavefront of the object radiation carries information of the irradiated object, e.g., 3D shape information. Based on the captured images of holograms, images of the object can be numerically reconstructed by using a computer reconstruction algorithm. An important advantage of hologram based metrology over intensity based metrology, as described in examples of Figures 7 and 8, is that hologram based metrology allows both intensity and phase information of an object to be obtained. With additional phase information, characteristics of the object can be determined with better accuracy.

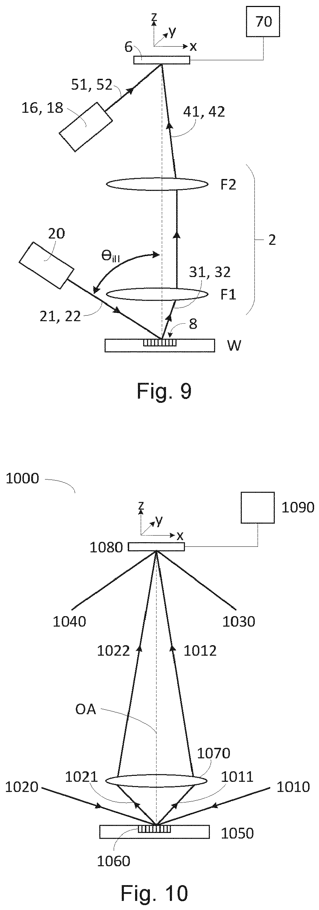

The international patent application WO2019197117A1, incorporated herein by reference, discloses a method and metrology apparatus based on a dark field digital holographic microscope (df-DHM) to determine a characteristic, e.g., overlay, of a structure manufactured on a substrate. For the purpose of description, Figure 3 of the international patent application WO2019197117A1 is replicated in Figure 9. Figure 9 schematically illustrates the disclosed df-DHM specifically adapted for use in lithographic process metrology.

In comparison to the former examples shown in Figures 7 and 8, the df-DHM in Figure 9 further comprises a reference optical unit 16, 18 which is used to provide additional two reference radiation beams 51, 52 (the reference radiation). Such two reference radiation beams 51, 52 are respectively paired with two corresponding portions 41, 42 of the scattered radiation beams 31, 32 (the object radiation). The two scattered-reference beam pairs are used sequentially to form two interference patterns. Coherence control is provided by way of adjusting the relative optical path-length difference (OPD) between the two scattered-reference beams within each beam pair. However, no coherence control is available between the two beam pairs.

Due to the use of a single light source and insufficient coherence control, all four radiation beams, i.e. the first portion 41 of the scattered radiation 31, the first reference radiation 51, the second portion 42 of the scattered radiation 32 and the second reference radiation 52, are mutually coherent. If these four mutually coherent radiation beams were allowed to reach the same position of the sensor 6 at the same time, namely operating in a parallel acquisition scheme, multiple interference patterns comprising desired information containing patterns and undesired artefact-contributing patterns would overlap each other. The undesired interference patterns may be formed by interference between e.g., the portion 41 of the first scattered radiation 31 and the portion 42 of the second scattered radiation 32. Since it would be technically challenging and time consuming to completely separate the superimposed interference patterns, parallel acquisition is impractical this arrangement.

Similar to the example of Figure 8, the use of a sequential acquisition scheme in the example of Figure 9 allows the full NA of the objective lens to be available for both illumination and detection. However, the system suffers the same problem of low measurement speed due to sequential acquisition. Therefore, it is desirable to have a df-DHM capable of performing parallel acquisition such that a high measurement speed and a high design flexibility can be simultaneously obtained.

Figure 10 schematically illustrates the imaging branch of a dark field digital holographic microscope (df-DHM) 1000. A dark field digital holographic microscope (df-DHM) comprises an imaging branch and an illumination branch. In this embodiment, a metrology target 1060 comprising a structure on a substrate 1050 is illuminated by two illumination beams of radiation, i.e., a first illumination beam of radiation 1010 and a second illumination beam of radiation 1020. In an embodiment, such two illumination beams 1010, 1020 may simultaneously illuminate the metrology target 1060.

In an embodiment, the first illumination beam 1010 may be incident on the metrology target 1060 at a first angle of incidence in a first direction with respect to the optical axis OA. The second illumination beam 1020 may be incident on the metrology target 1060 at a second angle of incidence in a second direction with respect to the optical axis OA. The first angle of incidence of the first illumination beam 1010 and the second angle of incidence of the second illumination beam 1020 may be substantially the same. The angle of incidence of each illumination beam may be, for example in the range of 70 degrees to 90 degrees, in the range of 50 degrees to 90 degrees, in the range of 30 degrees to 90 degrees, in the range of 10 degrees to 90 degrees. The illumination of the metrology target 1060 may result in radiation being scattered from the target. In an embodiment, the first illumination beam 1010 may be incident on the metrology target 1060 at a first azimuthal angle, corresponding to the first direction. The second illumination beam 1020 may be incident on the metrology target 1060 at a second azimuthal angle, corresponding to the second direction. The first azimuthal angle of the first illumination beam 1010 and the second azimuthal angle of the second illumination beam 1020 may be different; e.g., opposing angles 180 degrees apart.

Depending on the structure of the metrology target 1060, the scattered radiation may comprise reflected radiation, diffracted radiation or transmitted radiation. In this embodiment, the metrology target may be a diffraction-based overlay target; and each illumination beam may correspond to a scattered beam comprising at least one non-zeroth diffraction order. Each scattered beam carries information of the illuminated metrology target. For example, the first illumination beam 1010 may correspond to the first scattered beam 1011 comprising the positive first diffraction order +1^{st} DF; the second illumination beam 1020 may correspond to the second scattered beam 1021 comprising the negative first diffraction order -1^{st} DF. The zeroth diffraction order and other undesired diffraction orders may either be blocked by a beam blocking element (not shown) or configured to completely fall outside the NA of the objective lens 1070. As a result, the df-DHM may be operated in a dark field mode. Note that, in some embodiments, one or more optical elements, e.g., a lens combination, may be used to achieve same optical effect of the objective lens 1070.

Both scattered beams 1011, 1021 may be collected by objective lens 1070 and subsequently re-focused onto an image sensor 1080. Objective lens 1070 may comprise multiple lenses, and/or df-DHM 1000 may comprise a lens system having two or more lenses, e.g., an objective lens and an imaging lens similar to the exemplary df-DHm of Figure 9, thereby defining a pupil plane of the objective lens between the two lenses and an image plane at the focus of the imaging lens. In this embodiment, a portion 1012 of the first scattered beam 1011 and a portion 1022 of the second scattered beam 1021 are simultaneously incident at a common position of the image sensor 1080. At the same time, two reference beams of radiation, i.e. a first reference beam 1030 and a second reference beam 1040, are incident on the same position of the image sensor 1080. Such four beams may be grouped into two pairs of scattered radiation and reference radiation. For example, the first scattered-reference beam pair may comprise the portion 1012 of the first scattered beam 1011 and the first reference beam 1030. Likewise, the portion 1022 of the second scattered-reference beam pair may comprise the second scattered beam 1021 and the second reference beam 1040. These two scattered-reference beam pairs may subsequently form two interference patterns (holographic images) which at least partially overlap in spatial domain.

In an embodiment, in order to separate the two at least partially, spatially overlapping interference patterns (e.g., in the spatial frequency domain), the first reference beam 1030 may have a first angle of incidence with respect to the optical axis OA and the second reference beam 1040 may have a second angle of incidence with respect to the optical axis OA; the first angle of incidence and the second angle of incidence being different. Alternatively or in addition, the first reference beam 1030 may have a first azimuthal angle with respect to the optical axis OA and the second reference beam 1040 may have a second azimuthal angle with respect to the optical axis OA; the first and second azimuthal angles being different.

In order to generate an interference pattern, the two beams of each scattered-reference beam pair should be at least partially coherent to each other, to a degree which is sufficient to form an interference pattern. Note that each scattered radiation beam may have a phase offset with respect to its corresponding illumination radiation. For example, at the image plane of the image sensor 1080, such a phase offset may comprise contributions due to the optical path-length (OPD) from the metrology target 1060 to the image sensor 1080, and by the interaction with the metrology target. As described above, it is necessary to control the coherence between the first scattered-reference beam pair and the second scattered-reference beam pair such that each beam of one pair is incoherent to any beam of the other pair. In other words, interference should only occur between the beams within the same beam pair and suppressed between different beam pairs. In such a manner, only desired interference patterns, e.g., the two interference patterns formed by respect scattered-reference beam pairs, are formed in a superimposed manner on the image sensor 1080, thus obviating the problem of separating or removing undesired interference patterns.

The metrology devices described above may often use broadband radiation to enable measurement over a range of different wavelengths. In some cases, the full broadband radiation (or a wide range thereof) will be used for a measurement. However, more typically, one or more single wavelengths or narrow wavelength bands will be filtered out or selected in some manner for each measurement such that the illumination is configurable for a measurement.

Increasingly it is desirable that the range of selectable is wide, e.g., between 400nm and 1600nm or more. An illumination device (which may comprise the final portion of the illumination branch) may be positioned very close to the structure being measured during a measurement. It is designed to focus light in a similarly dimensioned (e.g., small) spot on the structure being measured regardless of the wavelength used. The illumination device, or each illuminator thereof, may comprise a lens or mirror which focusses the illumination into a spot on the structure being measured. It is increasingly difficult to design an illumination device which is able to operate accurately and in the same way for all wavelengths in a sufficiently large wavelength range.

As such, it is proposed to use an illumination device comprising a number of illuminators (or sets of illuminators), each illuminator/set of illuminators covering a respective smaller wavelength band. In this way each illuminator can be optimized for a smaller wavelength range, significantly reducing the design complexity. Each set of illuminators may be connected to the fixed-world optics (e.g., all optics outside of the sensor head) using its own set of fibers. In this way, the only additional component may be a fiber switch which can also reside in the fixed-world (outside of the sensor head).

As such, disclosed is an illumination device for a metrology apparatus; the illumination device comprising: a first set of illuminators comprising one or more illuminators which are each operable to emit first illumination comprising a first optical characteristic; a second set of illuminators, comprising one or more illuminators which are each operable to emit second illumination comprising a second optical characteristic different to said first optical characteristic.

The illumination device may comprise an illuminator holding means, such as an illuminator ring accommodating the first set of illuminators and the second set of illuminators. The central region within the illumination ring may be configured for receiving an optical system (e.g., an objective lens system) of the metrology device. The detection NA defined by the central detection region may be greater than 0.5, greater than 0.6, greater than 0.7, greater than 0.8 or in the region of 0.85 for example.

The first optical characteristic comprises at least a first wavelength range and/or first polarization, and the second optical characteristic comprises at least a second wavelength range and/or second polarization. In an embodiment, the first optical characteristic comprises at least a first illumination spot size and/or spot shape; and the second optical characteristic comprises at least a second illumination spot size and/or spot shape.

The first wavelength range may comprise a lower bound between 200nm and 600nm, between 300nm and 600nm, between 300nm and 500nm or approximately 400nm for example. The first wavelength range may comprise an upper bound between 700nm and 1300nm, between 800nm and 1200nm, between 900nm and 1 100nm or approximately 1000nm for example. The second wavelength range may comprise a lower bound between 700nm and 1300nm, between 800nm and 1200nm, between 900nm and 1100nm or approximately 1000nm for example. The second wavelength range may comprise an upper bound between 1300nm and 1900nm, between 1400nm and 1800nm, between 1500nm and 1700nm or approximately 1600nm for example. The first wavelength range may either partially overlap with the second wavelength range or there may be no overlap with the second wavelength range.

Each of said first set of illuminators and said second set of illuminators may comprise only a single illuminator.

The first set of illuminators and said second set of illuminators may each comprise at least a pair of illuminators, each pair of illuminators being operable to emit illumination from a pair of different directions. The pair of different directions may comprise substantially perpendicular directions (e.g., for simultaneous measurement of an x target and a y target). The pair of different directions may comprise substantially opposing directions (e.g., for simultaneous capture of two complementary diffraction orders such as the +1 and -1 diffraction orders).

The first set of illuminators and said second set of illuminators may each comprise two pairs of illuminators (e.g., spaced apart by 90 degrees). This allows simultaneous capture of two complementary diffraction orders such as the +1 and -1 diffraction orders from each of an x target and a y target.

The illuminator ring may be rotatable about a center point of the illuminator ring, the illuminator ring being configured to rotate the first set of illuminators and the second set of illuminators about the center point; e.g., to switch different sets of illuminators into position to allow measurement for a particular wavelength or wavelength range. Instead, the illuminator ring may be fixed with the sets of illuminators therefore fixed in place relative to the rest of the sensor module. In such as case, the substrate may be rotated as appropriate when illuminating using the first or second set of illuminators. In another embodiment, the illuminator ring may be fixed and the substrate not rotated. In such an example, the angular separation between the sets should be sufficiently small (e.g.., so corresponding illuminators of each set are very close together) In this case the illuminating beams (for at least one set of illuminators) would not be aligned perfectly with respect to the targets and they will therefore also illuminate the grating at a slightly oblique angle. Due to the limited NA of the illumination optics, the misalignment can be on the order of 7 degrees, resulting in some crosstalk. In such a case, it is proposed that this crosstalk may be suppressed with additional signal processing. The angular separation between the sets in such an embodiment may be less than 15 degrees, less than 10 degrees, less than 8 degrees, less than 6 degrees, or less than 4 degrees, for example.

The illumination device may comprise one or more additional sets of illuminators each operable to illuminate said structure with illumination comprising a respective additional optical characteristic (e.g., the full wavelength range may be divided into more than two sub-ranges with dedicated sets of illuminators for each sub-range).

The illumination device may form part of a sensor module or sensor head. The sensor module may comprise the illumination device, an optical system (e.g., comprising at least an objective lens) being operable to capture scattered radiation scattered by the structure resultant from the structure being illuminated; and a detector operable to detect the scattered radiation.

To keep the sensor module as compact and lightweight as possible, it may be kept physically separate from the bulk of the optics, the latter of which can be placed, for example, in a beam preparation module elsewhere in the machine (e.g., separate from the fixed world of which the illuminator box may form a part). The sensor module in this context may comprise at least an objective lens or lens arrangement and a detector; e.g., CCD/camera (and little else, e.g., only ancillary wiring etc.); for example objective lens 1070 and detector 1080 of Figure 10. The illuminator box may comprise an arrangement as described in EP3964892A1 and/or WO2021121733A1 for example. Both of these documents are incorporated herein by reference.

The following description will be described in the context of holography and a digital holographic microscope. In particular, the following description will be described in the context of a dark field digital holographic microscope. However, it should be appreciated that the concepts disclosed herein are not so limited, and may be applied to any suitable metrology apparatus including a scatterometer, alignment sensor, levelling sensor, bright-field DHM or any other such device.

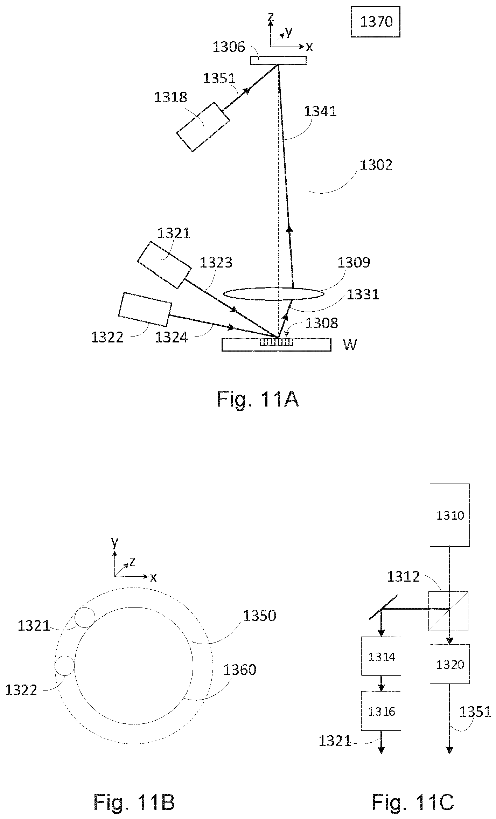

Figure 11A depicts a dark field digital holographic microscope (df-DHM) 1300 suitable for determining characteristic of interest of a structure 1308 (e.g. overlay) manufactured on a substrate W according to embodiments of the disclosure. The df-DHM 1300 in this example operates according to a sequential acquisition scheme, similar to the df-DHM of Figure 9.

In an embodiment, the df-DHM 1300 comprises a sensor module (not shown) comprising an illumination device for illuminating the structure 1308. The illumination device comprises at least a first set of illuminators and a second set of illuminators. The first set of illuminators comprise one or more illuminators which are each operable to illuminate said structure 1308 with first illumination 1323 comprising a first optical characteristic. The second set of illuminators comprise one or more illuminators which are each operable to illuminate said structure 1308 with second illumination 1324 comprising a second optical characteristic different to said first optical characteristic.

In the present example, the first optical characteristic comprises at least a first wavelength range; and the second optical characteristic comprises at least a second wavelength range. Further optical characteristics may be envisaged. In an embodiment, the first optical characteristic comprises at least a first polarization; and the second optical characteristic comprises at least a second polarization. In an embodiment, the first optical characteristic comprises at least a first illumination spot size; and the second optical characteristic comprises at least a second illumination spot size. In an embodiment, the first optical characteristic comprises at least a first illumination spot shape; and the second optical characteristic comprises at least a second illumination spot shape.

In the present example, the first set of illuminators comprises a first illuminator 1321; and the second set of illuminators comprises a second illuminator 1322. The first illuminator 1321 may be operable to illuminate the structure 1308 with a first wavelength range. The second illuminator 1322 may be operable to illuminate the structure 1308 with a second wavelength range. The wavelength ranges may be as defined as above. The sets of illuminators may comprise more than two sets of illuminators, each being operable to illuminate the structure 1308 with a respective different wavelength range.

In an embodiment, the first illumination 1321 may be incident on the structure 1308 at a first angle of incidence in a first direction with respect to the optical axis OA. The second illumination 1322 may be incident on the structure 1308 at a second angle of incidence in a second direction with respect to the optical axis OA. The first angle of incidence of the first illumination 1321 and the second angle of incidence of the second illumination 1322 may be substantially the same. The angle of incidence of each illumination beam may be, for example in the range of 70 degrees to 90 degrees, in the range of 50 degrees to 90 degrees, in the range of 30 degrees to 90 degrees, in the range of 10 degrees to 90 degrees.

The illumination by the first illumination 1323 on the structure 1308 may generate a first scattered radiation 1331 scattered by the structure 1308 resultant from the structure 1308 being illuminated by the first illumination 1323. The illumination by the second illumination 1324 on the structure 1308 may generate a second scattered radiation (not shown) scattered by the structure 1308 resultant from the structure 1308 being illuminated by the second illumination 1324.

The sensor module further comprises an optical system 1302 being operable to capture radiation scattered by the structure 1308 resultant from the structure 1308 being illuminated. In particular, the optical system is operable to capture the first scattered radiation 1331 resultant from the structure 1308 being illuminated by the first illumination 1323 and the second scattered radiation (not shown) resultant from the structure 1308 being illuminated by the second illumination 1324. In an embodiment, the optical system 1302 comprises an objective 1309. In an embodiment, the optical system 1302 comprises a planoconvex lens. The planoconvex lens is isoplanatic and has relatively high aberrations. In an embodiment, the optical system 1302 comprises a planoasphere lens or a bi-asphere lens. The planoasphere is non-isoplanatic and has relatively low aberrations. In an embodiment, the optical system 1302 comprises mirror optics. In an embodiment, the optical system 1302 defines a detection numerical aperture (NA). The detection NA defined by the central detection region may be greater than 0.5, greater than 0.6, greater than 0.7, greater than 0.8 or in the region of 0.85 for example.

The sensor module further comprises a detector 1306 operable to detect the scattered radiation.

The sensor module further comprises an illuminator ring (not shown) accommodating the first illuminator 1321 and the second illuminator 1331. In an embodiment, a central region of the illuminator ring is configured for receiving the optical system 1302. In an embodiment, the illuminator ring is rotatable about an optical axis of the optical system 1302. In an embodiment, the illuminator ring is configured to rotate the first set of illuminators and the second set of illuminators about the optical axis.

The optical system 1302 is configured to guide a portion 1341 of the first scattered radiation 1331 and/or a portion of the second scattered radiation from the structure 1308 to the detector 1306. The following is discussed in relation to the portion 1341 of the first scattered radiation, although substantially similar principles apply to guiding the portion of the second scattered radiation to the detector 1306. The portion 1341 of the first scattered radiation 1331 is thus the portion of the first scattered radiation 1331 that reaches the detector 1306. Other portions of the first scattered radiation 1341 do not reach the detector 1306. In an embodiment, the portion 1341 of the first scattered radiation 1331 reaching the detector 1306 excludes a specular reflection component of the first scattered radiation 1331. This may be achieved by arranging for a polar angle of incidence of the first illumination 1323 to be large enough to ensure that the specular reflection, which will occur at the same polar angle of incidence as the illumination, falls outside of the detection NA of the optical system 1302. The detection NA of the optical system 1302 may be a detection NA of the objective 1309. The detector 1306 thus may be arranged for dark field measurement. In an embodiment, the portion 1341 of the first scattered radiation 1331 consists at least predominantly of (i.e. more than half of or completely of) one or more non-zeroth order diffraction components, for example a +1 order diffraction component only or one or more of a +1, +2, +3 or higher order positive non-zeroth order diffraction component, scattered from the structure 1308.

In some embodiments, the sensor module is configured to illuminate the structure 1308 with first illumination 1323 from the first illuminator 1321 and second illumination 1324 from the second illuminator 1322 simultaneously. In some embodiments, the sensor module is configured to illuminate the structure 1308 with first illumination 1323 from the first illuminator 1321 and second illumination 1324 from the second illuminator 1322 separately or singly. In an embodiment, the sensor module is configured to switch between illuminating the structure 1308 with first illumination 1323 from the first illuminator 1321 and illuminating the structure 1308 with second illumination 1324 from the second illuminator 1322 by a rotation of the substrate W. In an embodiment, the sensor module is configured to switch between illuminating the structure 1308 with first illumination 1323 from the first illuminator 1321 and illuminating the structure 1308 with second illumination 1324 from the second illuminator 1322 by a rotation of the sensor module. In an embodiment, the sensor module is configured to switch between illuminating the structure 1308 with first illumination 1323 from the first illuminator 1321 and illuminating the structure 1308 with second illumination 1324 from the second illuminator 1322 by a rotation of the illuminator ring. In an embodiment, the sensor module is configured to switch between illuminating the structure 1308 with first illumination 1323 from the first illuminator 1321 and illuminating the structure 1308 with second illumination 1324 from the second illuminator 1322 by a combination of rotation of the illuminator ring, rotation of the substrate W, and/or rotation of the sensor module.

Figure 11B depicts schematically the geometric NA-space of the df-DHM 1300 illustrated in Figure 11A in accordance with an embodiment. The NA-space may comprise a peripheral illumination region 1350 surrounding a central detection region 1360 (i.e., the detection NA) comprising the optical system 1302. The first illuminator 1321 and the second illuminator 1322 are arranged within and/or to provide illumination within the peripheral illumination region 1350. The peripheral illumination region 1350 may be an NA region between a maximum NA of the system, and the detection NA. The maximum NA of the system may be 1 for non-immersion setups.

The first illumination 1323 may be incident on the structure 1308 from a first direction in the reference frame of the structure 1308. The second illumination 1324 may be incident on the structure 1308 from a second direction in the reference frame of the structure 1308. The first direction may be different to the second direction. For example, the first illumination 1323 may be incident on the structure 1306 at a first azimuthal angle, corresponding to the first direction, wherein the azimuthal angle of a beam refers to the angle between the x-axis and the incident beam or its projection in the x-y plane. The second illumination 1324 may be incident on the structure 1306 at a second azimuthal angle, corresponding to the second direction. The first azimuthal angle of the first illumination 1323 and the second azimuthal angle of the second illumination 1324 may be different; e.g., 45 degrees apart. It will be appreciated that the first direction may be the same as the second direction such that the first illumination 1323 and the second illumination 1324 originate from the same direction in the reference frame of the structure 1308.

As shown in Figure 11B, the first illuminator 1321 is arranged to provide illumination within the peripheral illumination region 1350 from a first direction, and the second illuminator 1322 is arranged to provide illumination within the peripheral illumination region 1350 from a second direction. In this embodiment, the first illuminator 1321 is arranged to provide illumination at a first azimuthal angle and the second illuminator 1322 is arranged to provide illumination at a second azimuthal angle, wherein an azimuthal angle separation between the first azimuthal angle and the second azimuthal angle is 45 degrees. It will be appreciated that any suitable azimuthal angle difference may be utilized. Where the illuminator ring is fixed, the azimuthal angle difference may be sufficiently small to mitigate the effects of crosstalk between the first illuminator 1321 and the second illuminator 1322.

In an embodiment, the df-DHM 1300 is further operable to provide respective first reference illumination 1351 corresponding to the first illumination 1323 and second reference illumination (not shown) corresponding to the second illumination 1324. In an embodiment, the first reference illumination 1351 and the second reference illumination comprises a plane wave or a spherical wave.

In an embodiment, the first reference illumination 1351 is provided by the first illuminator 1321 and the second reference illumination is provided by the second illuminator. The first illuminator 1321 provides the first reference illumination 1351 onto the detector 1306 at the same time as the portion 1341 of the first scattered radiation 1331. Similarly, the second illuminator 1322 provides the second reference illumination onto the detector 1306 at the same time as the portion of the second scattered radiation. Notably, the second reference illumination may be directed onto the detector 1306 at a different time to the first reference illumination 1351, in an embodiment where the first illuminator 1321 and the second illuminator 1322 are provided to the structure 1308 singly or separately.

The detector 1306 may be operable to detect a first interference pattern resulting from interference of the portion 1341 of the first scattered radiation 1331 reaching the detector 1306 and the first reference illumination 1351. The portion 1341 of the first scattered radiation 1331 reaching the sensor 1308 is at least sufficiently coherent at the sensor 1308 with the first reference illumination 1351 for the first interference pattern to be formed and for the first interference pattern to be detectable by the detector 1306. The first interference pattern is recorded by the detector 1306. Similarly, the detector is operable to detect a second interference pattern resulting from interference of the portion of the second scattered radiation reaching the detector 1306 and the second reference illumination.

Figure 11C depicts a schematic representation of an example arrangement of an illuminator, for example the first illuminator 1321 for providing the first illumination 1323 and the first reference illumination 1351. It will be appreciated that a substantially similar arrangement may be utilized for the second illuminator 1322 and the second reference illumination.

A radiation source 1310 provides a radiation beam to a beam splitter 1312. The radiation source 1310 generates a radiation beam of temporally and spatially coherent, or temporally and spatially partially coherent, or temporally coherent and spatially partially incoherent electromagnetic radiation (but sufficiently coherent for interference to take place at the detector 1306). In an embodiment, the radiation source 1310 of the first illuminator 1321 has a wavelength range of 400 nm to 1000 nm. In an embodiment, the radiation source (not shown) of the second first illuminator 1322 has a wavelength range of 1000 nm to 1600 nm.

In an embodiment wherein the first illumination 1323 and the second illumination 1324 originate from the same direction in the reference frame of the structure 1308, a single illuminator may be used and the radiation source may be configured to generate radiation at a controllable wavelength. In this embodiment, the radiation source may comprise a filtering unit for generating the radiation of a controllable wavelength from radiation having a broadband spectral distribution.

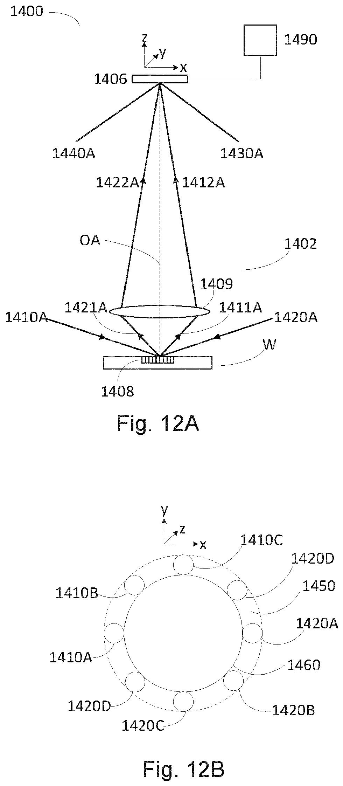

The radiation beam is split by the beam splitter 1312 to provide the first illumination 1323 and the first reference illumination 1351. In the example shown, a first part of the split radiation beam, representing the first reference illumination 1351, passes through a delay element 1314 and a reference optical unit 1316. The reference optical unit 1316 directs the first reference illumination 1351 onto the detector 1306. A second part of the split radiation beam, representing the first illumination 1323, passes through an illumination optical unit 1320. The illumination optical unit 1320 directs the first illumination 1323 onto the structure 1308. An optical path length between a point where the radiation beam is split by the beam splitter 1312 and the detector 1306 may be adjusted by the delay element 1314. The delay element 1314 may comprise any suitable arrangement for introducing a phase delay, for example by controllably increasing a path length of the radiation passing through the delay element 1314. The delay element 1314 may be implemented based on the principles discussed with reference to Figure 12 of WO 2019/197117, for example, involving mirrors. In the present example, the delay element 1314 is provided in the optical path between the beam splitter 1312 and the reference optical unit 1316, but a delay element 1314 could alternatively or additionally be provided in the optical path between the beam splitter 1312 and the illumination optical unit 1320. In some embodiments the path difference is set to be equal for each of the two optical paths between the beam splitter 1312 and the detector 1306 (i.e. via the structure 1308 and not via the structure 1308). This condition may be met by tuning the phase element 1314 and/or by accurate alignment of optical elements between the beam splitter 1312 and the detector 1306.

At a subsequent time following illumination of the structure 1308 with the first illumination 1323, the structure 1308 may be illuminated with an additional first illumination (not shown). The additional first illumination may be incident on the structure 1308 from a different direction to the first illuminator 1321 in the reference frame of the structure 1308. For example, the first illumination 1323 may be incident on the structure 1306 at the first azimuthal angle, corresponding to the first direction and the additional first illumination may be incident on the structure 1306 at a third azimuthal angle, corresponding to a third direction. The first direction and the third direction may be substantially opposing directions. For example, the first azimuthal angle may be angularly separated from the third azimuthal angle by 180 degrees. The difference in direction may be implemented by changing the direction of illumination in the reference frame of the optical system 1302, by rotating the substrate W (e.g. by 180 degrees), or by a combination of changing the direction of illumination in the reference frame of the optical system 1302 and rotating the substrate W. The direction of illumination in the reference frame of the optical system 1302 may be changed by, for example, rotating the rotatable ring.

Similarly, at a subsequent time following illumination of the structure 1308 with the second illumination 1324, the structure 1308 may be illuminated with an additional second illumination (not shown). The additional second illumination may be incident on the structure 1308 from a different direction to the second illumination in the reference frame of the structure 1308. For example, the second illumination may be incident on the structure 1306 at the second azimuthal angle, corresponding to the second direction and the additional second illumination may be incident on the structure 1306 at a fourth azimuthal angle, corresponding to a fourth direction. The second direction and the fourth direction may be substantially opposing directions. For example, the second azimuthal angle may be angularly separated from the fourth azimuthal angle by 180 degrees. The difference in direction may be implemented by changing the direction of illumination in the reference frame of the optical system 1302, by rotating the substrate W (e.g. by 180 degrees), or by a combination of changing the direction of illumination in the reference frame of the optical system 1302 and rotating the substrate W. The direction of illumination in the reference frame of the optical system 1302 may be changed by, for example, rotating the rotatable ring.

An additional first interference pattern is formed by interference between a portion of an additional first scattered radiation of the additional first illumination reaching the detector 1306 and an additional first reference illumination. The portion of the additional first scattered radiation reaching the sensor 1308 is at least sufficiently coherent at the sensor 1308 with the additional first reference illumination for the additional first interference pattern to be formed and for the additional first interference pattern to be detectable by the detector 1306. The additional first interference pattern is recorded by the detector 1306. Similarly, an additional second interference pattern is formed by interference between a portion of the additional second scattered radiation reaching the detector 1306 and an additional second reference illumination.

One or more characteristics of the structure 1308 may be determined by a processing unit 1370 of the df-DHM 1300. The processing unit 1370 may use the first interference pattern and the additional first interference pattern recorded by the detector 1306 to determine a characteristic of the structure 1308 according to the first optical characteristic. The processing unit 1370 may also use the second interference pattern and the additional second interference pattern recorded by the detector 1306 to determine a characteristic of the structure 1308 according to the second optical characteristic.

In an embodiment, the processing unit 1370 is coupled to the detector 1306 to receive a signal comprising information about the interference patterns recorded by the detector 1306. In an embodiment, the processing unit 1370 corrects for aberrations of the optical system 1302.

Note that the aforementioned embodiments may be further generalized for df-DHMs having a sensor module, wherein said first set of illuminators and said second set of illuminators each comprise a plurality of pairs of illuminators operable to illuminate the structure from different directions. The first set of illuminators and said second set of illuminators may each comprise at least a pair of illuminators, each pair of illuminators being operable to emit illumination from a pair of different directions. The pair of different directions may comprise substantially perpendicular directions (e.g., for simultaneous measurement of an x target and a y target). The pair of different directions may comprise substantially opposing directions (e.g., for simultaneous capture of two complementary diffraction orders such as the +1 and -1 diffraction orders). The first set of illuminators and said second set of illuminators may each comprise two pairs of illuminators (e.g., spaced apart by 90 degrees). This allows simultaneous capture of two complementary diffraction orders such as the +1 and -1 diffraction orders from each of an x target and a y target.

Figure 12A depicts a dark field digital holographic microscope (df-DHM) 1400 suitable for determining a characteristic of interest of a structure 1408 (e.g. overlay) manufactured on a substrate W according to embodiments of the disclosure. The df-DHM 1400 in this example operates according to a parallel acquisition scheme, similar to the df-DHM of Figure 10.

In an embodiment, the df-DHM 1400 comprises a sensor module (not shown) comprising an illumination device for illuminating the structure 1408. The illumination device comprises at least a first set of illuminators and a second set of illuminators. The first set of illuminators comprise one or more illuminators which are each operable to illuminate said structure 1408 with first illumination comprising a first optical characteristic. The second set of illuminators comprise one or more illuminators which are each operable to illuminate said structure 1408 with second illumination comprising a second optical characteristic different to said first optical characteristic.

In some embodiments, the illumination device further comprises one or more additional sets of illuminators each operable to illuminate said structure 1408 with illumination comprising a respective additional optical characteristic. In the present example, the one or more additional sets of illuminators comprises a third set of illuminators and a fourth set of illuminators. The third set of illuminators comprise one or more illuminators which are each operable to illuminate said structure 1408 with third illumination comprising a third optical characteristic. The fourth set of illuminators comprise one or more illuminators which are each operable to illuminate said structure 1408 with fourth illumination comprising a third optical characteristic

In some embodiments, each set of illuminators each comprise at least a pair of illuminators, each pair of illuminators being operable to illuminate the structure 1408 from a pair of different directions. Each illuminator of a set of illuminators is configured to illuminate the structure 1408 simultaneously. This may be similar to the pair of illuminators of the df-DHM of Figure 10. In further embodiments, each set of illuminators may comprise a set (e.g., a pair) of x-illuminators and a set (e.g., a pair) of y-illuminators. It will be appreciated that the plurality of sets of illuminators may comprise any suitable number of sets of illuminators.

Each set of illuminators comprises a different optical characteristic. In this embodiment, each set of illuminators comprises a different wavelength range. For example, the first set of illuminators comprises a first wavelength range of 400 nm to 700 nm, the second set of illuminators comprises a second wavelength range of 700 nm to 1000 nm, the third set of illuminators comprises a third wavelength range of 1000 nm to 1300 nm, and the fourth set of illuminators comprises a fourth wavelength range of 1300 nm to 1600 nm. In some embodiments, a first wavelength range may partially overlap with a second wavelength range. It will be appreciated that each set of illuminators may comprise any suitable wavelength range. Further optical characteristics may be envisaged. In an embodiment, the first optical characteristic comprises at least a first polarization; the second optical characteristic comprises at least a second polarization; the third optical characteristic comprises at least a third polarization; and the fourth optical characteristic comprises at least a fourth polarization. In an embodiment, the first optical characteristic comprises at least a first illumination spot size; the second optical characteristic comprises at least a second illumination spot size, the third optical characteristic comprises at least a third illumination spot size, and the fourth optical characteristic comprises at least a fourth illumination spot size.

In this embodiment, the first set of illuminators comprises a first illuminator 1410A and an additional first illuminator 1420A. The first illuminator 1410A and the additional first illuminator 1420A may be operable to illuminate the structure 1408 with the first wavelength range. The second illuminator and the additional second illuminator may be operable to illuminate the structure 1408 with the second wavelength range. The second set of illuminators comprises a second illuminator (not shown) and an additional second illuminator (not shown). The second illuminator and the additional second illuminator may be operable to illuminate the structure 1408 with the second wavelength range. The third set of illuminators comprises a third illuminator (not shown) and an additional third illuminator (not shown). The third illuminator and the additional third illuminator may be operable to illuminate the structure 1408 with the third wavelength range. The fourth set of illuminators comprises a fourth illuminator (not shown) and an additional fourth illuminator (not shown). The fourth illuminator and the additional fourth illuminator may be operable to illuminate the structure 1408 with the fourth wavelength range.

The illumination of the structure 1408 may result in radiation being scattered from the structure 1408. Depending on the structure of the structure 1408, the scattered radiation may comprise reflected radiation, diffracted radiation or transmitted radiation. In this embodiment, the structure 1408 may be a diffraction-based overlay target; and each illuminator may correspond to a scattered beam comprising at least one non-zeroth diffraction order. Each scattered beam carries information of the illuminated structure 1408. For example, the first illuminator 1410A may correspond to a first scattered radiation 1411A comprising a positive first diffraction order +1^{st} DF and the additional first illuminator 1420B may correspond to an additional first scattered radiation 1421A comprising a negative first diffraction order -1^{st} DF. The second illuminator 1410B may correspond to a third scattered beam (not shown) comprising a positive first diffraction order +1^{st} DF and the additional second illuminator 1420B may correspond to a fourth scattered beam (not shown) comprising a negative first diffraction order - 1^{st} DF. The third illuminator 1410C may correspond to a fifth scattered beam (not shown) comprising a positive first diffraction order +1^{st} DF and the additional third illuminator 14020C may correspond to a sixth scattered beam (not shown) comprising a negative first diffraction order -1st DF. The fourth illuminator 1410D may correspond to a seventh scattered beam (not shown) comprising a positive first diffraction order +1^{st} DF and the additional fourth illuminator 1420D may correspond to an eighth scattered beam (not shown) comprising a negative first diffraction order -1st DF.

The sensor module further comprises an optical system 1402 being operable to capture radiation scattered by the structure 1408 resultant from the structure 1408 being illuminated. For example, the optical system is operable to capture first scattered radiation 1411A resultant from the structure 1408 being illuminated by the first illumination 1410A, and an additional first scattered radiation 1421A resultant from the structure 1408 being illuminated by the additional first illumination 1420A. In an embodiment, the optical system 1402 comprises an objective lens 1409. In an embodiment, the optical system 1402 comprises a planoconvex lens. The planoconvex lens is isoplanatic and has relatively high aberrations. In an embodiment, the optical system 1402 comprises a planoasphere lens or a bi-asphere lens. The planoasphere is non-isoplanatic and has relatively low aberrations. In an embodiment, the optical system 1402 comprises mirror optics. In an embodiment, the optical system 1402 defines a detection numerical aperture (NA). The detection NA defined by the central detection region may be greater than 0.5, greater than 0.6, greater than 0.7, greater than 0.8 or in the region of 0.85 for example. Note that, in some embodiments, one or more optical elements, e.g., a lens combination, may be used to achieve same optical effect of the objective lens 1409.

The sensor module further comprises a detector 1306 operable to detect the scattered radiation.

The sensor module further comprises an illuminator ring (not shown) accommodating the first sets of illuminators, the second set of illuminators, the third set of illuminators, and the fourth set of illuminators. In an embodiment, a central region of the illuminator ring is configured for receiving the optical system 1402. In an embodiment, the illuminator ring is rotatable about an optical axis of the optical system 1402. In an embodiment, the illuminator ring is configured to rotate the first sets of illuminators, the second set of illuminators, the third set of illuminators, and the fourth set of illuminators about the optical axis.

The scattered radiation of each set of illuminators may be collected by the objective lens 1409, and subsequently re-focused onto a detector 1406. The objective lens 1409 may comprise multiple lenses, and/or df-DHM 1400 may comprise a lens system having two or more lenses, e.g., an objective lens and an imaging lens similar to the exemplary df-DHM of Figure 9, thereby defining a pupil plane of the objective lens between the two lenses and an image plane at the focus of the imaging lens.

In some embodiments, the sensor module is configured to illuminate the structure 1308 with illumination from each set of illuminators simultaneously. In some embodiments, the sensor module is configured to illuminate the structure 1308 with each set of illuminators separately or singly. In some embodiments, the sensor module is configured to switch between illumination from each set of illuminators by a rotation of the substrate W. In an embodiment, the sensor module is configured to switch between illumination from each set of illuminators by a rotation of the sensor module. In an embodiment, the sensor module is configured to switch between illumination from each set of illuminators by a rotation of the illuminator ring. In an embodiment, the sensor module is configured to switch between illumination from each set of illuminators by a combination of rotation of the illuminator ring, rotation of the substrate W, and/or rotation of the sensor module.

The incident angle of an illumination refers to the angle in the x-z plane between the optical axis (dashed line) of the microscope or the z-axis and the incident illumination or its projection in the x-z plane. The first illuminator 1410A may provide first illumination incident on the structure 1408 at a first angle of incidence in a first direction with respect to the optical axis OA. The additional first illuminator 1420A may provide additional first illumination incident on the structure 1408 at a second angle of incidence in a second direction with respect to the optical axis OA. The second illuminator may provide second illumination incident on the structure 1408 at a third angle of incidence in a third direction with respect to the optical axis OA. The additional second illuminator may provide additional second illumination incident on the structure 1408 at a fourth angle of incidence in a fourth direction with respect to the optical axis OA. The third illuminator may provide third illumination incident on the structure 1408 at a fifth angle of incidence in a fifth direction with respect to the optical axis OA. The additional third illuminator may provide additional third illumination incident on the structure 1408 at a sixth angle of incidence in a sixth direction with respect to the optical axis OA. The fourth illuminator may provide fourth illumination incident on the structure 1408 at a seventh angle of incidence in a seventh direction with respect to the optical axis OA. The additional fourth illuminator may provide additional fourth illumination incident on the structure 1408 at an eighth angle of incidence in an eighth direction with respect to the optical axis OA. The angle of incidence of each illuminator may be substantially the same. The angle of incidence of each illuminator may be, for example in the range of 70 degrees to 90 degrees, in the range of 50 degrees to 90 degrees, in the range of 30 degrees to 90 degrees, in the range of 10 degrees to 90 degrees.

Figure 12B depicts schematically the geometric NA-space of the df-DHM 1400 illustrated in Figure 12A in accordance with an embodiment. The NA-space may comprise a peripheral illumination region 1450 surrounding a central detection region 1460 (i.e., the detection NA) comprising the optical system 1402. The illuminators are arranged within and/or to provide illumination within the peripheral illumination region 1450.

As shown in Figure 12B, each illuminator is arranged within or to provide illumination at a respective position within the peripheral region 1450. The second illuminator is labelled 1410B, the additional second illuminator is labelled 1420B, the third illuminator is labelled 1410C, the additional third illuminator is labelled 1420C, the fourth illuminator is labelled 1410D, and the additional fourth illuminator is labelled 1420D. In this embodiment, the azimuthal angles of each of the illuminators are angularly separated from adjacent illuminators by 45 degrees. In some embodiments, the illuminators are evenly angularly distributed, however this need not be the case. It will be appreciated that any suitable azimuthal angle separation may be utilized.

The azimuthal angle of a beam refers to the angle between the x-axis and the incident beam or its projection in the x-y plane. The first illuminator 1410A may provide first illumination incident on the structure 1408 at a first azimuthal angle, corresponding to the first direction. The additional first illuminator 1420A may provide additional first illumination incident on the structure 1408 at a second azimuthal angle, corresponding to the second direction. The first azimuthal angle and the second azimuthal angle may be different; e.g., opposing angles 180 degrees apart. The second illuminator may provide second illumination incident on the structure 1408 at a third azimuthal angle, corresponding to the third direction. The additional second illuminator may provide additional second illumination incident on the structure 1408 at a fourth azimuthal angle, corresponding to the fourth direction. The third azimuthal angle and the fourth azimuthal angle may be different; e.g., opposing angles 180 degrees apart. The third illuminator may provide third illumination incident on the structure 1408 at a fifth azimuthal angle, corresponding to the fifth direction. The additional third illuminator may provide additional third illumination incident on the structure 1408 at a sixth azimuthal angle, corresponding to the sixth direction. The fifth azimuthal angle and the sixth azimuthal angle may be different; e.g., opposing angles 180 degrees apart. The fourth illuminator may provide fourth illumination incident on the structure 1408 at a seventh azimuthal angle, corresponding to the seventh direction. The additional fourth illuminator may provide additional fourth illumination incident on the structure 1408 at an eighth azimuthal angle, corresponding to the eighth direction. The seventh azimuthal angle and the eighth azimuthal angle may be different; e.g., opposing angles 180 degrees apart.

In an embodiment, the azimuthal angles of each of the illuminators are evenly distributed around the x-y plane. For example, the first azimuthal angle and the third azimuthal angle may be different, e.g., 45 degrees apart. The third azimuthal angle and the fifth azimuthal angle may be different, e.g., 45 degrees apart. The fifth azimuthal angle and the fifth seventh azimuthal angle may be different, e.g., 45 degrees apart. The second azimuthal angle and the fourth azimuthal angle may be different, e.g., 45 degrees apart. The fourth azimuthal angle and the sixth azimuthal angle may be different, e.g., 45 degrees apart. The sixth azimuthal angle and the eighth azimuthal angle may be different, e.g., 45 degrees apart. It will be appreciated that the azimuthal angles need not be evenly distributed, and that there may be an uneven distribution of azimuthal angles.

In an example embodiment wherein the first set of illuminators are illuminating the structure 1408, a portion 1412A of the first scattered radiation 1411A and a portion 1422A of the additional first scattered radiation 1421A are simultaneously incident at a common position of the detector 1406. At the same time, the df-DWM is further operable to provide two reference beams of radiation, i.e. a first reference illumination 1430A and an additional first reference illumination 1440A, are incident on the same position of the detector 1406. Such four beams may be grouped into two pairs of scattered radiation and reference radiation. For example, the first scattered-reference illumination pair may comprise the portion 1412A of the first scattered radiation 1411A and the first reference illumination 1430. Likewise, the portion 1422A of an additional first scattered-reference illumination pair may comprise the additional first scattered radiation 1421A and the additional first reference illumination 1420A. These two scattered-reference illumination pairs may subsequently form two interference patterns (holographic images) which at least partially overlap in spatial domain.

It will be appreciated that each set of illuminators may have a corresponding set of reference illuminations. For example, a second scattered-reference illumination pair may comprise the portion of the second scattered beam and a second reference illumination (not shown). Likewise, the portion 1422A of an additional first scattered-reference illumination pair may comprise the additional first scattered radiation 1421A and an additional second reference illumination (not shown). In some embodiments, the additional second reference illumination is the same as the first reference illumination, such that one or more sets of illuminators utilizes the same reference illumination.

In an embodiment, the first illumination, the additional first illumination, the first reference illumination 1430A, and the additional first reference illumination 1440A may be provided by an illumination branch comprising the first illuminator 1410A. Similarly, the second illumination device may provide the second illumination, the additional second illumination, the second reference illumination, and the additional second reference illumination. The third illumination device may provide the third illumination, the additional third illumination, the third reference illumination, and the additional third reference illumination. The fourth illumination device may provide the fourth illumination, the additional fourth illumination, the fourth reference illumination, and the additional fourth illumination. In an embodiment, the illumination devices may be substantially similar to the illumination device of Figure 11 or Figure 12 of WO2021/121733.

One or more characteristics of the structure 1408 may be determined by a processing unit 1490 of the df-DHM 1400. When, for example, the first illumination device 1410A is used, the processing unit 1490 uses the first interference pattern and the additional first interference pattern recorded by the detector 1406 to determine the characteristic of the structure 1408. In an embodiment, the processing unit 1490 is coupled to the detector 1406 to receive a signal comprising information about the first interference pattern and the additional first interference pattern recorded by the sensor 1490. In an embodiment, the processing unit 1490 corrects for aberrations of the objective lens 1409 of the df-DHM 1400. In an embodiment, the measurements of the first interference pattern and the additional first interference pattern are performed with radiation simultaneously in time (in parallel) and the processing unit 1490 is configured to use the measurements simultaneously in time (in parallel) to determine the characteristic of the structure 1408 according to the first optical characteristic. This determination may be repeated for each of the other illumination devices, such that characteristics of the structure are determined according to the second, third, and/or fourth optical characteristic.

Note that the aforementioned embodiments may be further generalized for df-DHMs having sets of a plurality of illuminators pairs of illumination and reference radiation beams. In some embodiments, the df-DHM having a sensor module, wherein the sets of illuminators each comprises two pairs of illuminators operable to illuminate the structure from four different directions. In some embodiments, the four different directions are spaced by substantially 90 degrees.

In some embodiments, the illuminators may provide a plurality of pairs of illuminations and reference illuminations. The illuminators may also provide sufficient coherence control between radiation illuminations such that only desired interference patterns will be formed on the detector.

In an embodiment, the processing unit 1490 may be a computer system. The computer system may be equipped with an image reconstruction algorithm which is used to perform all the aforementioned tasks, comprising performing Fourier transform, extracting each individual high order spatial spectrum, performing inverse Fourier transform, calculating complex fields and determining a characteristic of the structure based on the results.

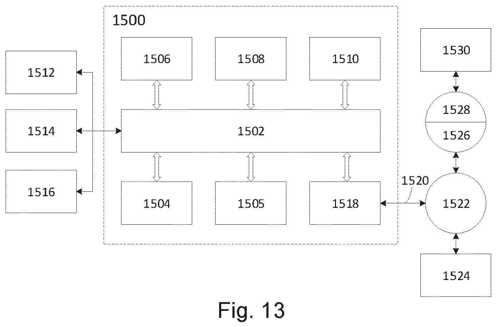

Figure 13 is a block diagram that illustrates a computer system 1500 that may assist in implementing the methods and flows disclosed herein. Computer system 1500 includes a bus 1502 or other communication mechanism for communicating information, and a processor 1504 (or multiple processors 1504 and 1505) coupled with bus 1502 for processing information. Computer system 1500 also includes a main memory 1506, such as a random access memory (RAM) or other dynamic storage device, coupled to bus 1502 for storing information and instructions to be executed by processor 1504. Main memory 1506 also may be used for storing temporary variables or other intermediate information during execution of instructions to be executed by processor 1504. Computer system 1500 further includes a read only memory (ROM) 1408 or other static storage device coupled to bus 1502 for storing static information and instructions for processor 1504. A storage device 1510, such as a magnetic disk or optical disk, is provided and coupled to bus 1502 for storing information and instructions.

Computer system 1500 may be coupled via bus 1502 to a display 1512, such as a cathode ray tube (CRT) or flat panel or touch panel display for displaying information to a computer user. An input device 1514, including alphanumeric and other keys, is coupled to bus 1502 for communicating information and command selections to processor 1504. Another type of user input device is cursor control 1516, such as a mouse, a trackball, or cursor direction keys for communicating direction information and command selections to processor 1504 and for controlling cursor movement on display 1512. This input device typically has two degrees of freedom in two axes, a first axis (e.g., x) and a second axis (e.g., y), that allows the device to specify positions in a plane. A touch panel (screen) display may also be used as an input device.

One or more of the methods as described herein may be performed by computer system 1500 in response to processor 1504 executing one or more sequences of one or more instructions contained in main memory 1506. Such instructions may be read into main memory 1506 from another computer-readable medium, such as storage device 1510. Execution of the sequences of instructions contained in main memory 1506 causes processor 1504 to perform the process steps described herein. One or more processors in a multi-processing arrangement may also be employed to execute the sequences of instructions contained in main memory 1506. In an alternative embodiment, hard-wired circuitry may be used in place of or in combination with software instructions. Thus, the description herein is not limited to any specific combination of hardware circuitry and software.

The term "computer-readable medium" as used herein refers to any medium that participates in providing instructions to processor 1504 for execution. Such a medium may take many forms, including but not limited to, non-volatile media, volatile media, and transmission media. Non-volatile media include, for example, optical or magnetic disks, such as storage device 1510. Volatile media include dynamic memory, such as main memory 1506. Transmission media include coaxial cables, copper wire and fiber optics, including the wires that comprise bus 1502. Transmission media can also take the form of acoustic or light waves, such as those generated during radio frequency (RF) and infrared (IR) data communications. Common forms of computer-readable media include, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge, a carrier wave as described hereinafter, or any other medium from which a computer can read.

Various forms of computer readable media may be involved in carrying one or more sequences of one or more instructions to processor 1504 for execution. For example, the instructions may initially be borne on a magnetic disk of a remote computer. The remote computer can load the instructions into its dynamic memory and send the instructions over a telephone line using a modem. A modem local to computer system 1500 can receive the data on the telephone line and use an infrared transmitter to convert the data to an infrared signal. An infrared detector coupled to bus 1502 can receive the data carried in the infrared signal and place the data on bus 1502. Bus 1502 carries the data to main memory 1506, from which processor 1504 retrieves and executes the instructions. The instructions received by main memory 1506 may optionally be stored on storage device 1510 either before or after execution by processor 1504.

Computer system 1500 also preferably includes a communication interface 1518 coupled to bus 1502. Communication interface 1518 provides a two-way data communication coupling to a network link 1520 that is connected to a local network 1522. For example, communication interface 1518 may be an integrated services digital network (ISDN) card or a modem to provide a data communication connection to a corresponding type of telephone line. As another example, communication interface 1518 may be a local area network (LAN) card to provide a data communication connection to a compatible LAN. Wireless links may also be implemented. In any such implementation, communication interface 1518 sends and receives electrical, electromagnetic or optical signals that carry digital data streams representing various types of information.

Network link 1520 typically provides data communication through one or more networks to other data devices. For example, network link 1520 may provide a connection through local network 1522 to a host computer 1524 or to data equipment operated by an Internet Service Provider (ISP) 1526. ISP 1526 in turn provides data communication services through the worldwide packet data communication network, now commonly referred to as the "Internet" 1428. Local network 1522 and Internet 1528 both use electrical, electromagnetic or optical signals that carry digital data streams. The signals through the various networks and the signals on network link 1520 and through communication interface 1518, which carry the digital data to and from computer system 1500, are exemplary forms of carrier waves transporting the information.

Computer system 1500 may send messages and receive data, including program code, through the network(s), network link 1520, and communication interface 1518. In the Internet example, a server 1430 might transmit a requested code for an application program through Internet 1528, ISP 1526, local network 1522 and communication interface 1518. One such downloaded application may provide for one or more of the techniques described herein, for example. The received code may be executed by processor 1504 as it is received, and/or stored in storage device 1510, or other non-volatile storage for later execution. In this manner, computer system 1500 may obtain application code in the form of a carrier wave.

Further embodiments are disclosed in the subsequent list of numbered clauses:
1. A sensor module for a metrology apparatus, the sensor module comprising:
   an illumination device for illuminating a structure on a substrate, said illumination device comprising at least a first set of illuminators and a second set of illuminators, wherein said first set of illuminators comprise one or more illuminators which are each operable to illuminate said structure with first illumination comprising a first optical characteristic and wherein said second set of illuminators comprise one or more illuminators which are each operable to illuminate said structure with second illumination comprising a second optical characteristic different to said first optical characteristic;
   an optical system being operable to capture scattered radiation scattered by the structure resultant from the structure being illuminated; and
   a detector operable to detect the scattered radiation.
2. A sensor module as defined in clause 1, wherein the first optical characteristic comprises at least a first wavelength range, and the second optical characteristic comprises at least a second wavelength range.
3. A sensor module as defined in clause 1 or 2, wherein the first optical characteristic comprises at least a first polarization, and the second optical characteristic comprises at least a second polarization.
4. An illumination device as defined in any preceding clause, wherein the first optical characteristic comprises at least a first spot size , and the second optical characteristic comprises at least a second spot size.
5. An illumination device as defined in any preceding clause, wherein the first optical characteristic comprises at least a first spot shape, and the second optical characteristic comprises at least a second spot shape.
6. A sensor module as defined in any preceding clause, wherein:
   said first set of illuminator and second set of illuminators are arranged within and/or to provide illumination within a peripheral illumination region, said peripheral illumination region surrounding a central detection region comprising said optical system.
7. A sensor module as defined in any preceding clause, wherein a detection numerical aperture defined by the central detection region is greater than 0.7.
8. A sensor module as defined in any preceding clause, wherein a detection numerical aperture defined by the central detection region is greater than 0.8.
9. A sensor module as defined in any preceding clause, wherein said illumination device comprises one or more additional sets of illuminators each operable to illuminate said structure with illumination comprising a respective additional optical characteristic.
10. A sensor module as defined in any preceding clause, wherein each of said first set of illuminators and said second set of illuminators each comprise a single illuminator.
11. A sensor module as defined in any of clauses 1 to 9, wherein said first set of illuminators and said second set of illuminators each comprise at least a pair of illuminators, each pair of illuminators being operable to illuminate the structure from a pair of different directions.
12. A sensor module as defined in clause 11, wherein the pair of different directions comprise substantially perpendicular directions.
13. A sensor module as defined in clause 11, wherein the pair of different directions comprise substantially opposing directions.
14. A sensor module as defined in any of clauses 1 to 9, wherein said first set of illuminators and said second set of illuminators each comprise two pairs of illuminators operable to illuminate the structure from four different directions.
15. A sensor module as defined in clause 14, wherein the four different directions are spaced by substantially 90 degrees.
16. A sensor module as defined in any preceding clause, configured to illuminate the structure with first illumination from the first set of illuminators and second illumination from the second set of illuminators simultaneously.
17. A sensor module as defined in clause 16, wherein first set of illuminators and said second set of illuminators comprise an azimuthal angular separation which is sufficient so as to minimize crosstalk between the first illuminator and the second illuminator.
18. A sensor module as defined in any of clauses 1 to 15, configured to illuminate the structure with first illumination from the first set of illuminators and second illumination from the second set of illuminators separately.
19. A sensor module as defined in clause 18, configured to switch between illuminating the structure with first illumination from the first set of illuminators and illuminating the structure with second illumination from the second set of illuminators by a rotation of the substrate and/or sensor module.
20. A sensor module as defined in any preceding clause, further comprising an illuminator holding means accommodating the first set of illuminators and the second set of illuminators, the illuminator holding means being an illuminator ring rotatable about an optical axis of the optical system, the illuminator ring being configured to rotate the first set of illuminators and the second set of illuminators about the optical axis.
21. A sensor module as defined in any of clauses 1 to 20, wherein each set of illuminators comprises respective different optical elements such that said optical elements are the same within each set of illuminators, but differ between the different sets of illuminators.
22. A sensor module as defined in clause 21, wherein the optical elements are optimized for their respective optical characteristic.
23. A digital holographic microscope configured to determine a characteristic of interest of a structure, comprising the sensor module of any preceding clause.
24. A digital holographic microscope as defined in clause 23, being further operable to provide respective first reference illumination having a first optical characteristic corresponding to the first illumination and second reference illumination having a second optical characteristic corresponding to the second illumination.
25. A digital holographic microscope as defined in clause 23 or 24, wherein said detector is operable to detect: a first interference pattern resulting from interference of first scattered radiation resulting from scattering of the first illumination by the structure and the first reference illumination; and a second interference pattern resulting from interference of second scattered radiation resulting from scattering of the second illumination and the second reference illumination.
26. A digital holographic microscope as defined in any of clauses 23 to 25, comprising a dark-field digital holographic microscope.
27. A scatterometer configured to determine a characteristic of interest of a structure, comprising the sensor module of any of clauses 1 to 22.
28. An alignment sensor comprising the sensor module of any of clauses 1 to 22.
29. A level sensor comprising the sensor module of any of clauses 1 to 22.
30. An illumination device for a metrology apparatus; the illumination device comprising:
   a first set of illuminators comprising one or more illuminators which are each operable to emit first illumination comprising a first optical characteristic
   a second set of illuminators, comprising one or more illuminators which are each operable to emit second illumination comprising a second optical characteristic different to said first optical characteristic; and
   an illuminator holding means accommodating the first set of illuminators and the second set of illuminators.
31. An illumination device as defined in clause 30, wherein the first optical characteristic comprises at least a first wavelength range, and the second optical characteristic comprises at least a second wavelength range.
32. An illumination device as defined in clause 30 or 31, wherein the first optical characteristic comprises at least a first polarization, and the second optical characteristic comprises at least a second polarization.
33. An illumination device as defined in any of clauses 30 to 32, wherein the first optical characteristic comprises at least a first spot size, and the second optical characteristic comprises at least a second spot size.
34. An illumination device as defined in any of clauses 30 to 33, wherein the first optical characteristic comprises at least a first spot shape, and the second optical characteristic comprises at least a second spot shape.
35. An illumination device as defined in any of clauses 30 to 34, wherein:
   a central region within the illumination ring is configured for receiving optical system of the metrology device.
36. An illumination device as defined in any of clauses 30 to 35, wherein the illuminator holding means is an illuminator ring rotatable about a center point of the illuminator ring, the illuminator ring being configured to rotate the first set of illuminators and the second set of illuminators about the center point.
37. An illumination device as defined in any of clauses 30 to 36, wherein each of said first set of illuminators and said second set of illuminators each comprise a single illuminator.
38. An illumination device as defined in any of clauses 30 to 36, wherein said first set of illuminators and said second set of illuminators each comprise at least a pair of illuminators, each pair of illuminators being operable to emit illumination from a pair of different directions.
39. An illumination device as defined in clause 38, wherein the pair of different directions comprise substantially perpendicular directions.
40. An illumination device as defined in clause 38, wherein the pair of different directions comprise substantially opposing directions.
41. An illumination device as defined in any of clauses 30 to 36, wherein said first set of illuminators and said second set of illuminators each comprise two pairs of illuminators operable to emit illumination from four different directions.
42. An illumination device as defined in clause 41, wherein the four different directions are spaced by substantially 90 degrees.
43. An illumination device as defined in any of clauses 30 to 42, wherein said illumination device comprises one or more additional sets of illuminators each operable to illuminate said structure with illumination comprising a respective additional optical characteristic.
44. An illumination device as defined in any of clauses 30 to 43, wherein first set of illuminators and said second set of illuminators comprise an azimuthal angular separation which is sufficient so as to minimize crosstalk between the first illumination beam and the second illumination beam.
45. An illumination device as defined in any of clauses 30 to 44, wherein each set of illuminators comprises respective different optical elements such that said optical elements are the same within each set of illuminators, but differ between the different sets of illuminators.
46. A illumination device as defined in clause 45, wherein the optical elements are optimized for their respective optical characteristic.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A sensor module for a metrology apparatus, the sensor module comprising:
an illumination device for illuminating a structure on a substrate, said illumination device comprising at least a first set of illuminators and a second set of illuminators, wherein said first set of illuminators comprise one or more illuminators which are each operable to illuminate said structure with first illumination comprising a first optical characteristic and wherein said second set of illuminators comprise one or more illuminators which are each operable to illuminate said structure with second illumination comprising a second optical characteristic different to said first optical characteristic;
an optical system being operable to capture scattered radiation scattered by the structure resultant from the structure being illuminated; and
a detector operable to detect the scattered radiation.

2. A sensor module as claimed in claim 1, wherein at least one of:
- the first optical characteristic comprises at least a first wavelength range, and the second optical characteristic comprises at least a second wavelength range,
- the first optical characteristic comprises at least a first polarization, and the second optical characteristic comprises at least a second polarization,
- the first optical characteristic comprises at least a first spot size, and the second optical characteristic comprises at least a second spot size, and
- the first optical characteristic comprises at least a first spot shape, and the second optical characteristic comprises at least a second spot shape.

3. A sensor module as claimed in any preceding claim, wherein:
said first set of illuminator and second set of illuminators are arranged within and/or to provide illumination within a peripheral illumination region, said peripheral illumination region surrounding a central detection region comprising said optical system.

4. A sensor module as claimed in any preceding claim, wherein a detection numerical aperture defined by the central detection region is greater than 0.7.

5. A sensor module as claimed in any preceding claim, wherein said illumination device comprises one or more additional sets of illuminators each operable to illuminate said structure with illumination comprising a respective additional optical characteristic.

6. A sensor module as claimed in any preceding claim, wherein each of said first set of illuminators and said second set of illuminators each comprise a single illuminator.

7. A sensor module as claimed in any of claims 1 to 5, wherein said first set of illuminators and said second set of illuminators each comprise at least a pair of illuminators, each pair of illuminators being operable to illuminate the structure from a pair of different directions.

8. A sensor module as claimed in claim 7, wherein at least one of:
- the pair of different directions comprise substantially perpendicular directions; and
- the pair of different directions comprise substantially opposing directions.

9. A sensor module as claimed in any of claims 1 to 5, wherein said first set of illuminators and said second set of illuminators each comprise two pairs of illuminators operable to illuminate the structure from four different directions.

10. A sensor module as claimed in claim 9, wherein the four different directions are spaced by substantially 90 degrees.

11. A sensor module as claimed in any preceding claim, configured to illuminate the structure with first illumination from the first set of illuminators and second illumination from the second set of illuminators simultaneously.

12. A sensor module as claimed in claim 16, wherein first set of illuminators and said second set of illuminators comprise an azimuthal angular separation which is sufficient so as to minimize crosstalk between the first illuminator and the second illuminator.

13. A sensor module as claimed in any preceding claim, further comprising an illuminator holding means accommodating the first set of illuminators and the second set of illuminators, the illuminator holding means being an illuminator ring rotatable about an optical axis of the optical system, the illuminator ring being configured to rotate the first set of illuminators and the second set of illuminators about the optical axis.

14. A digital holographic microscope configured to determine a characteristic of interest of a structure, comprising the sensor module of any preceding claim.

15. A scatterometer configured to determine a characteristic of interest of a structure, comprising the sensor module of any of claims 1 to 13.
